# EUROPÄISCHE PATENTSCHRIFT

(11) **EP 3 851 847 B1**
(45) Veröffentlichungstag und Bekanntmachung des Hinweises auf die Patenterteilung: **17.09.2025**
(21) Anmeldenummer: 21151073.0
(22) Anmeldetag: 12.01.2021
(51) Int. Cl.: G01N 27/87, G01N 27/9013, G01N 29/22, G01N 29/26, G01N 29/265, G01N 27/9093

(54) **SONDENEINRICHTUNG FÜR EINEN ROTIERKOPF MIT BIEGEFEDER, TRÄGERARM UND PRÜFGERÄT**
PROBE DEVICE FOR A ROTARY HEAD WITH BENDING SPRING, CARRIER ARM AND TEST DEVICE
DISPOSITIF DE SONDE POUR UNE TÊTE ROTATIVE À RESSORT DE FLEXION, BRAS PORTEUR ET APPAREIL DE VÉRIFICATION

(30) Priorität: 16.01.2020 DE 102020200480
(43) Veröffentlichungstag der Anmeldung: 21.07.2021
(73) Patentinhaber: Prüftechnik Dieter Busch GmbH, 85737 Ismaning (DE)
(72) Erfinder: Peters, Jürgen, 85652 Pliening (DE)
(74) Vertreter: Spengler, Robert

(56) Entgegenhaltungen:
- WO-A1-2009/041139
- DE-A1- 102015 214 232
- DE-A1- 2 945 586
- DE-A1- 3 240 146
- DE-A1- 4 121 948

## Beschreibung

Die vorliegende Erfindung betrifft eine Sondeneinrichtung für einen Rotierkopf, die wenigstens einen um eine Drehachse drehbar gelagerten Trägerarm, wenigstens eine mit dem Trägerarm verbundene Sonde sowie wenigstens ein an dem Rotierkopf abstützbares und an dem Trägerarm angreifendes Federelement aufweist, das zum Ausüben einer Kraft auf den Trägerarm vorgesehen ist, der infolge dieser Kraft ein Drehmoment bezüglich der Drehachse erfährt. Ferner betrifft die Erfindung einen Rotierkopf mit wenigstens einer derartigen Sondeneinrichtung und ein Prüfgerät mit wenigstens einer derartigen Sondeneinrichtung und/oder mit wenigstens einem derartigen Rotierkopf.

Insbesondere für die Untersuchung von stabförmigen runden metallischen Halbzeugen auf Fehler wie Risse und Lunker mittels Wirbelstrom- oder Streufluss-Verfahren kommen Prüfgeräte zum Einsatz, die als Rotiersysteme ausgebildet sind. Bei derartigen Rotiersystemen sind Sondeneinrichtungen an drehbaren Rotierköpfen des Prüfgeräts angeordnet. Indem der Rotierkopf mitsamt den daran angeordneten Sondeneinrichtungen gedreht wird während ein länglicher Prüfling durch eine mittige Durchlassöffnung durch den Rotierkopf hindurch geschoben wird, bewegen sich die Sondeneinrichtungen relativ zum Prüfling auf einer schraubenförmigen Bahn. Um Magnetfeldänderungen infolge von Fehlerstellen des Prüflings erfassen zu können, müssen sich für das Wirbelstrom-Verfahren vorgesehene Sonden der Sondeneinrichtungen in einem vorgegebenen Abstand bzw. möglichst nahe an der Oberfläche des Prüflings befinden. Beim Streufluss-Verfahren hingegen stehen die Sonden in Kontakt mit dem Prüfling und schleifen auf dessen Oberfläche. Sie nutzen sich dabei ab und müssen regelmäßig ersetzt werden. Aus diesen Gründen sollte der Anpressdruck der Sonden auf die Oberfläche des Prüflings möglichst gering sein, ohne dass die Sonden vom Prüfling abheben, da ein Abheben der Sonde die Prüfung stört oder gar verhindert.

So ist aus der DE 10 2012 108 241 A1 eine Sondeneinrichtung bzw. ein Sondenträger für ein als Rotiersystem ausgebildetes Prüfgerät zur zerstörungsfreien Prüfung eines langgestreckten Prüflings mittels Streufluss oder Wirbelströmen bekannt. Der Sondenträger ist modular und steckbar ausgeführt, so dass die Anpassung des Prüfgeräts an einen veränderten Prüflingsdurchmesser schnell erfolgen kann.

Andere bekannte Sondeneinrichtungen, wie beispielsweise die in der DE 10 2015 214 232 A1 gezeigte Sondeneinrichtung, weisen einen um einen Drehpunkt frei beweglich gelagerten Trägerarm auf. An einem Ende des nach Art eines zweiseitigen Hebels gelagerten Trägerarms ist die Sonde angeordnet und am diesem Ende entgegengesetzten Ende des Trägerarms ist ein Gegengewicht vorgesehen. Mittels einer am Trägerarm angreifenden und am Rotierkopf angebrachten Zugfeder wird auf den Trägerarm eine Kraft und somit ein Drehmoment bewirkt. Sofern sich ein Prüfling beispielsweise unregelmäßig durch die Durchlassöffnung des Rotierkopfes bewegt, können die Sonden infolge der drehbaren Lagerung des sie tragenden Trägerarms entsprechend ausweichen. Mittels des Gegengewichtes sowie der am Trägerarm angreifenden Zugfeder lässt sich eine Position der Sonde in einem vorgegebenen Abstand von der Oberfläche des Prüflings sowie gegebenenfalls eine Anpresskraft der Sonde auf den Prüfling bei einer vorgegebenen Drehzahl des Rotierkopfes und einem vorgegebenen Durchmesser des Prüflings einstellen.

Die DE 41 21 948 A1 betrifft einen Sondenträger für die Wirbelstrom-Werkstoffprüfung, der an einem Prüfrotor festlegbar ist und wenigstens zwei schwenkbar gelagerte Sondenhebel trägt. Die Sondenhebel sind mit einer Zugfeder in eine Ruhelage vorgespannt.

Aus der DE 29 45 586 A1 ist eine Mehrfachhalterung für Ultraschall-Prüfköpfe bekannt. Je ein Prüfkopf ist dabei in Doppelanordnung an je einem freien Wippenende einer schwenkbaren Wippe kardanisch aufgehängt.

Während des Drehens des Rotierkopfes ist das Federelement Zentrifugalkräften ausgesetzt. Je nach Drehzahl des Rotierkopfes und je nach der Position des Trägerarmes ändert sich die vom Federelement auf den Trägerarm ausgeübte Kraft, und somit ändert sich auch das auf den Trägerarm wirkende Drehmoment um die Drehachse. Hierdurch wird insbesondere die Anpresskraft bzw. die Position der Sonden in Bezug auf den Prüfling beeinflusst. Erhöht sich die Anpresskraft der Sonde auf den Prüfling, so erhöht sich der Sondenverschleiß. Verringert sich hingegen die Anpresskraft, so können die Sonden je nachdem, ob es sich bei der Prüfung um ein Streufluss- oder Wirbelstrom-Verfahren handelt, vom Prüfling abheben oder ihren Abstand zum Prüfling vergrößern, wodurch die Prüfung gestört oder gänzlich unmöglich gemacht wird.

Damit bei großen Prüflingen und entsprechenden Drehzahlen des Rotierkopfes die Sonden nicht von der Oberfläche des Prüflings abheben, wodurch der Prüfungsvorgang beim Streufluss-Verfahren unterbrochen wird, ist man in der Praxis dazu geneigt, die Federkraft und damit die Anpresskraft der Sonde auf den Prüfling übermäßig hoch auszubilden oder die Drehzahl des Rotierkopfes zu verringern. Eine große Anpresskraft führt jedoch zu einer verstärkten Abnutzung der auf der Prüflingsoberfläche schleifenden Sonden, während eine Verringerung der Drehzahl des Rotierkopfes zu einem verringerten Durchsatz des Prüflings führt. Auch die korrekte Einstellung des Abstandes der Sonden von der Oberfläche des Prüflings im Wirbelstrom-Verfahren gestaltet sich gemeinhin aufgrund der Einflüsse von Drehzahl und Prüflingsdurchmesser in der Praxis als schwierig.

Es ist daher die Aufgabe der vorliegenden Erfindung, eine Sondeneinrichtung, einen Rotierkopf und ein Prüfgerät zu schaffen, welche eine von Zentrifugalkräften unabhängige Einstellung von Sonden bezüglich eines Prüflings ermöglichen.

Diese Aufgabe wird durch die Sondeneinrichtung mit den Merkmalen des Anspruchs 1, durch den Rotierkopf mit den Merkmalen des Anspruchs 9 und durch das Prüfgerät mit den Merkmalen des Anspruchs 10 gelöst.

Während bei bekannten Sondeneinrichtungen das Federelement zumeist als Zugfeder ausgeführt ist, die an einer von der Drehachse beabstandeten Stelle am Trägerarm angreift, so dass sich der Anpressdruck der Sonde auf den Prüfling mit der Drehzahl der Rotierkopfes oder mit dem Prüflingsdurchmesser ändert, weist der Trägerarm bei der erfindungsgemäßen Sondeneinrichtung wenigstens eine mit der Drehachse konzentrische Aufnahme für das Federelement auf, das an der Aufnahme angeordnet sowie mit wenigstens einer Wicklung um die Aufnahme gewickelt und um die Drehachse gekrümmt ist. Mit anderen Worten wird die Drehachse vom Federelement umschlungen bzw. das Federelement ist um die Drehachse geschlungen oder gewickelt.

Dabei kann das Federelement die Aufnahme bzw. die Drehachse mit wenigstens einer oder mehreren Wicklungen umschlingen bzw. einmal oder mehrmals um die Aufnahme bzw. die Drehachse gewickelt sein. Dabei greift das um die Drehachse gekrümmte oder gewickelte Federelement an einer von der Drehachse beabstandeten Stelle am Trägerarm an. Diese Stelle kann sich insbesondere auf der Aufnahme befinden, sie kann aber auch von der Aufnahme beabstandet sein.

Ganz allgemein kann der Trägerarm eine Längsachse aufweisen, wobei die Längsachse und die Drehachse zueinander windschief ausgebildet sein können. Der Trägerarm bzw. dessen Längsachse kann die Drehachse aber auch schneiden. Ferner kann die Sonde an den Enden zweier oder mehrerer zueinander parallel angeordneter Trägerarme befestigt sein, die alle um dieselbe Drehachse drehbar gelagert sind. Zudem kann zur Einstellung der Anpresskraft oder Position der Sonde wenigstens ein Gegengewicht am Trägerarm angeordnet sein, dessen Lage vorteilhafterweise entlang des Trägerarmes verstellbar ist.

Weil das Federelement um die zur Drehachse konzentrische Aufnahme und damit auch um die Drehachse gekrümmt oder gewickelt ist, wird das Federelement bei Einwirken von Zentrifugalkräften gegen die Aufnahme gedrückt, ohne dass dadurch Biegespannungen in dem Federelement erzeugt werden. Somit kann das Federelement auch keine durch Zentrifugalkräfte verursachten Kräfte auf den Trägerarm ausüben und folglich keine Drehmomente an diesem bewirken. Vielmehr bleibt der Trägerarm für beliebige Drehzahlen des Rotierkopfes und beliebige Prüflingsdurchmesser ausgewogen. Ein Abheben oder Entfernen der Sonden vom Prüfling unterbleibt selbst dann, wenn die Drehzahl des Rotierkopfes hoch ist. Wegen der stets optimal bzw. geringstmöglich eingestellten Anpresskraft verringert sich zudem der Verschleiß der Sonden, so dass sich Standzeiten der Sonden und Wartungsintervalle deutlich verlängern. Da der Anpressdruck der Sonde ausschließlich über die Federkraft erzeugt wird und der Trägerarm nur einmalig, beispielsweise mittels geeigneter Gegengewichte, ausgewogen werden muss, entfällt ein Nacharbeiten an Gegengewichten zur Einstellung der Anpresskraft der Sonden an oder des Abstandes der Sonden von der Oberfläche des Prüflings. Ein solches nachträgliches Anpassen von Gegengewichten ist nur noch dann erforderlich, falls verschieden schwere Sonden zum Einsatz kommen. Insbesondere ist eine durchmesserabhängige Anpassung des Gegengewichtes oder gar eine zwangsweise Reduktion der Liniengeschwindigkeit nicht mehr erforderlich. Weil erforderliche Drehzahlen des Rotierkopfes stets erreicht werden können, wird auch die Produktivität von Prüfvorrichtungen mit erfindungsgemäßen Sondeneinrichtungen erhöht.

Bei dem Federelement kann es sich insbesondere um eine Biegefeder wie z.B. eine Spiral- oder Elliptik- oder Parabel- oder Wellen- oder Draht- oder Schenkelfeder handeln. Als Biegefedern werden gemeinhin Körper bezeichnet, die durch eine Biegung unter einem Biegemoment elastisch verformbar sind, wodurch eine Biegespannung im Körper erzeugt wird. Zu den Biegefedern gehören beispielsweise Spiralfedern, also stark gekrümmte Metallbänder, die in einer Ebene in einer Schneckenlinie aufgewickelt sind. Dagegen bestehen Elliptikfedern aus schwach gebogener Blattfedern, die zumeist als Federpakete mit aufeinander liegenden einzelnen Federblättern paarweise gegeneinander montiert sind. Bei Parabelfedern werden anstelle eines abgestuften Federpaketes Blattfedern mit parabelförmig von der Mitte zu den Enden hin abnehmender Stärke verwendet. Wellenfedern wiederum sind Ringe aus gewelltem Flachdraht, bei denen bei Belastung Wellen heraus gebogen werden. Wellenfedern können zu Paketen übereinander geschichtet oder einlagig eingesetzt werden. Im Unterschied zu Blattfedern mit rechteckigem Querschnitt bestehen Drahtfedern aus Drähten. Zu den Drahtfedern gehören unter anderem Schenkelfedern, bei denen es sich um schraubenförmig gewickelte beziehungsweise gewundene Drahtfedern mit abstehenden geraden Enden oder Schenkeln handelt, die zur Einleitung eines den Draht biegenden Drehmoments dienen.

Grundsätzlich kann das Federelement mit dem Trägerarm fest oder lösbar verbunden bzw. an diesem fixiert sein. Entsprechend kann das Federelement dadurch am Rotierkopf abgestützt sein, dass es an einer geeigneten Stelle des Rotierkopfes oder einem dafür vorgesehenen Element des Rotierkopfes fest oder lösbar mit diesem verbunden ist. Bevorzugt ist allerdings eine Ausführungsform der Sondeneinrichtung, bei der das Federelement nicht mit dem Rotierkopf verbunden ist sondern stattdessen einen Stützabschnitt, beispielsweise einen Endabschnitt, zum Abstützen an einem bzw. zum Anlegen an einen Anschlag des Rotierkopfes aufweist. Eine derartige Ausführungsform hat den besonderen Vorteil, dass ein einfaches Austauschen des einzelnen Federelements möglich ist, wenn das Federelement am Trägerarm bzw. an dessen Aufnahme nicht montiert ist, oder dass bei fester oder loser Montage des Federelements am Trägerarm ein Austauschen des Trägerarms oder gar der gesamten Sondeneinrichtung möglich ist, ohne dass dazu ein Lösen oder Trennen des Federelementes vom Rotierkopf notwendig wäre. Ebenso einfach gestaltet sich der Einbau eines neuen Federlelements bzw. des Trägerarms bzw. der Sondeneinrichtung.

Die erfindungsgemäße Sondeneinrichtung ist für beliebige Rotationssysteme geeignet, und zwar auch für solche, bei denen Sonden beweglich an Trägerarmen aufgehängt sind. Auch für berührungslose Prüfverfahren kann eine mechanische Drehwinkelbegrenzung für den Trägerarm und/oder die Sonde vorgesehen sein, an welcher der Trägerarm oder die Sonde mit leichtem Druck anliegt, so dass dieselbe möglichst leicht ausweichen kann. Hierdurch wird die Aufprallenergie des Prüflings auf Sondenabweiser verringert.

Da die Sonde der Sondeneinrichtung eine Verbindung mit der Auswerteeinheit benötigt um beispielsweise Messsignale an die Auswerteeinheit übertragen zu können, werden Sondenkabel von der Sonde durch den Trägerarm geführt. Sondenkabel verlaufen oftmals als Kabelbögen oder Schlaufen von einem Anschluss oder Einlass am Rotierkopf zur Sondeneinrichtung und in einer Kabelführung derselben über einen Trägerarm der Sondeneinrichtung geführt zur Sonde, um die Beweglichkeit des Trägerarms zu gewährleisten. Wie die Federelemente bekannter Sondeneinrichtungen erfahren auch diese Kabelbögen bei Drehen des Rotierkopfes eine Zentrifugalkraft und üben dadurch ein Drehmoment auf den Trägerarm aus, wodurch sie die Anpresskraft bzw. die Position der Sonden in Bezug auf den Prüfling beeinflussen.

Zur Verringerung oder Vermeidung derartiger Drehmomente weist die Sondeneinrichtung vorzugsweise wenigstens eine Kabelführung zum Führen eines Sondenkabels auf, wobei die Kabelführung einen entlang des Trägerarms von der Sonde zur Drehachse verlaufenden ersten Endabschnitt und einen im Wesentlichen von der Drehachse ausgehenden zweiten Endabschnitt aufweist. Mit anderen Worten liegen sowohl der erste Endabschnitt als auch der zweite Endabschnitt im Wesentlichen mit einem ihrer Enden an der Drehachse an bzw. eines ihrer jeweiligen Enden ist im Wesentlichen an der Drehachse positioniert bzw. eines ihrer jeweiligen Enden befindet sich auf der Höhe der Drehachse. Sowohl der erste Endabschnitt als auch der zweite Endabschnitt schließen damit mit der Drehachse einen Winkel ein. Hierdurch wird bewirkt, dass ein Sondenkabel auf der Höhe der Drehachse des Trägerarms der Sondeneinrichtung bzw. deren Sonde zugeführt oder von dieser abgeführt wird. Infolgedessen kann das Sondenkabel keinerlei Drehmoment auf den Trägerarm bewirken, wenn sowohl die Sondeneinrichtung als auch das Sondenkabel als Teil eines Rotierkopfes eines Rotiersystems gedreht werden und eine Zentrifugalkraft erfahren. Somit kann das Sondenkabel auch keinerlei Einfluss auf die Einstellung der Position der Sonde oder deren Anpresskraft auf die Oberfläche von Prüflingen ausüben.

Es sind Ausführungsformen der Sondeneinrichtung möglich, bei denen der erste Endabschnitt und der zweite Endabschnitt direkt miteinander verbunden sind. In diesen Fällen gehen die beiden Endabschnitte im Wesentlichen am Drehpunkt des Trägerarms ineinander über. Bei anderen Ausführungsformen der Sondeneinrichtung verbindet ein entlang der Drehachse verlaufender Kabelführungsabschnitt den ersten Endabschnitt und den zweiten Endabschnitt miteinander. Beispielsweise kann der erste Endabschnitt von der Sonde zur Drehachse oder zum Drehpunkt des Trägerarms führen, wo er in den zur Drehachse parallelen Kabelführungsabschnitt mündet, welcher wiederum entlang der Drehachse vom Drehpunkt des Trägerarms wegführt und von diesem entfernt in den zweiten Endabschnitt mündet.

Bei der erfindungsgemäßen Sondeneinrichtung kann der Trägerarm nach Art eines einseitigen oder eines zweiseitigen Hebels gelagert sein. In beiden Fällen kann die Sonde an einem Ende oder Endabschnitt des Trägerarms mit diesem verbunden sein. Ist der Trägerarm nach Art eines zweiseitigen Hebels gelagert, so ist vorzugsweise außer der Sonde wenigstens ein Gegengewicht am Trägerarm befestigt, wobei sich Sonde und Gegengewicht bezüglich der Drehachse des Trägerarmes auf entgegengesetzten Seiten, und zwar bevorzugt an entgegengesetzten Enden oder Endabschnitten des Trägerarms befinden.

Vorteilhaft weist ein erfindungsgemäßer Rotierkopf wenigstens eine erfindungsgemäße Sondeneinrichtung auf. Durch geeignete Auswahl der Federkonstante des Federelements kann zur Einstellung der Position der Sonde relativ zum Prüfling bzw. der Anpresskraft der Sonde an den Prüfling beigetragen werden.

Ein erfindungsgemäßes Prüfgerät weist bevorzugt wenigstens ein Paar an Sondeneinrichtungen auf, deren Sonden einander zugewandt angeordnet sind. Wird ein Prüfling zwischen den Sonden angeordnet oder hindurchgeschoben, so können die Sonden simultan zwei einander entgegengesetzte Seiten des Prüflings überprüfen.

Die Erfindung wird nachfolgend anhand von Zeichnungen näher erläutert. Es zeigen:
- Figur 1: einen Rotierkopf gemäß dem Stand der Technik mit zwei Sondeneinrichtungen;
- Figur 2: eine Sondeneinrichung gemäß dem Stand der Technik;
- Figur 3: eine schematische Seitenansicht der Sondeneinrichung der Figur 2;
- Figur 4: eine schematische Seitenansicht einer erfindungsgemäßen Sondeneinrichtung;
- Figur 5: eine räumliche Darstellung einer erfindungsgemäßen Sondeneinrichtung;
- Figur 6: eine räumliche Darstellung einer Sondeneinrichtung mit einer Kabelführung.

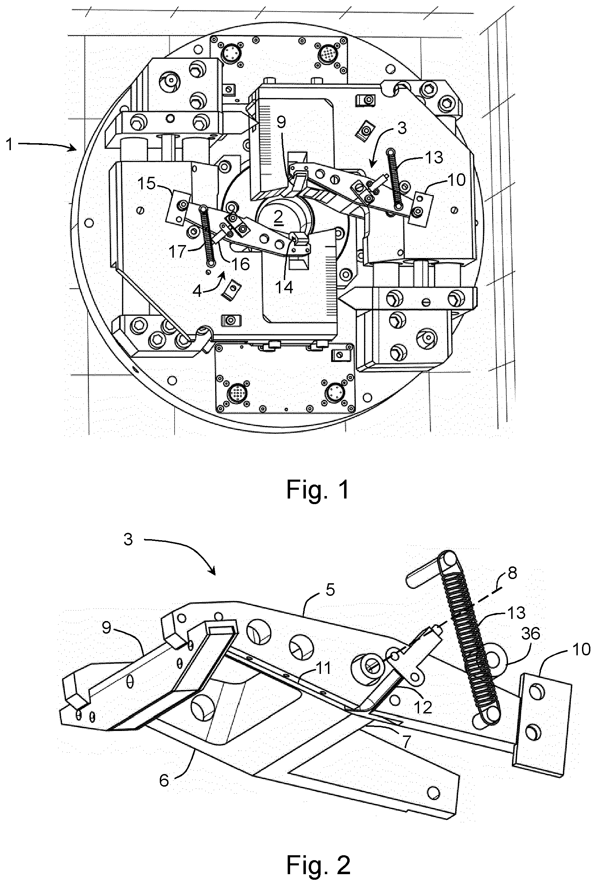

In der Figur 1 ist ein bekannter kreisförmiger Rotierkopf 1 eines als Rotiersystem ausgebildeten Prüfgerätes dargestellt. Der Rotierkopf 1 weist ein zentrales Durchgangsloch 2 und zwei im Wesentlichen identisch ausgebildete Sondeneinrichtungen 3 und 4 auf.

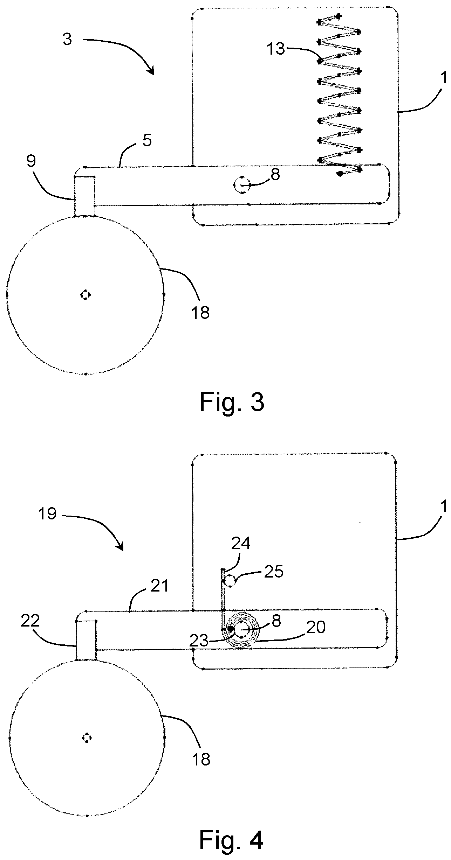

Die Sondeneinrichtung 3 ist in der Figur 2 vergrößert und in der Figur 3 in einer schematischen Seitenansicht zu sehen. Sie umfasst zwei längliche Trägerarme 5 und 6, die parallel zueinander angeordnet und mittels eines im Wesentlichen mittig angeordneten Mittelsteges 7 miteinander verbunden sind. Auf der Höhe des Mittelsteges 7 sind die Trägerarme 5 und 6 nach Art eines zweiseitigen Hebels um eine in der Figur 2 gestrichelt eingezeichnete Drehachse 8 drehbar gelagert. Von den dem Durchgangsloch 2 zugewandten Enden der Trägerarme 5 und 6 wird eine sich zwischen den Trägerarmen 5 und 6 erstreckende Sonde 9 gehalten, während an dem dem Durchgangsloch 2 abgewandten Ende des Trägerarmes 5 ein Gegengewicht 10 angeordnet ist. Ferner weist die Sondeneinrichtung 3 eine Kabelführung mit einem von der Sonde 9 ausgehenden und entlang des Trägerarms 5 verlaufenden ersten Endabschnitt 11 und einem sich an den ersten Endabschnitt 11 anschließenden zweiten Endabschnitt 12 auf, wobei der zweite Endabschnitt 12 die Drehachse 8 weder schneidet noch von ihr ausgeht. Die Kabelführung ist zur Aufnahme eines in den Figuren aus Gründen der Übersichtlichkeit nicht dargestellten Sondenkabels vorgesehen. Schließlich greift eine Schraubenzugfeder oder Schraubenfeder 13 an einer Stelle zwischen dem Mittelsteg 7 und dem Gegengewicht 10 an dem Trägerarm 5, mithin an einem von der Sonde 9 abgewandten Endabschnitt des Trägerarms 5 an.

Die Sondeneinrichtung 4 entspricht in ihrem Aufbau im Wesentlichen der Sondeneinrichtung 3. Insbesondere weist auch die Sondeneinrichtung 4 eine Sonde 14 auf, die an Endabschnitten ihrer Trägerarme befestigt ist. An einem der Sonde 14 entgegengesetzten Ende eines Trägerarmes der Sondeneinrichtung 4 ist ein Gegengewicht 15 vorgesehen. Aus der räumlichen Perspektive der Figur 1 ist von der Kabelführung der Sondeneinrichtung 4 lediglich der zweite Endabschnitt 16 sichtbar. Eine Schraubenfeder 17 greift mit einem Ende an einem von der Sonde 14 abgewandten Endabschnitt des Trägerarms der Sondeneinrichtung 4 an einer Stelle zwischen dem zweiten Endabschnitt 16 der Kabelführung und dem Gegengewicht 15 an dem Trägerarm an.

Im Rotierkopf 1 sind die beiden Sondeneinrichtungen 3 und 4 derart angeordnet, dass sich deren jeweilige Sonden 9 und 14 in Bezug auf das Durchgangsloch 2 im Wesentlichen diametral gegenüberliegen.

Im Betrieb des Prüfgerätes wird nun ein von den Sonden 9 und 14 zu prüfendes, längliches Prüfstück 18 durch das Durchgangsloch 2 geschoben, während der Rotierkopf 1 um das Prüfstück 18 rotiert. Durch geeignete Wahl der Gegengewichte 10 und 15 der Sondeneinrichtungen 3 und 4 sowie der an den Sondeneinrichtungen 3 und 4 angreifenden Schraubenfedern 13 und 17 kann die Anpresskraft, mit der die Sonden 9 und 14 auf die Oberfläche des Prüfstückes 18 drücken, eingestellt werden. Der Abstand zum Prüfstück 18 wird bei berührungslosen Verfahren mittels mechanischen Drehwinkelbegrenzungen wie zum Beispiel dem in der Figur 2 für die Sondeneinrichtung 3 dargestellten Begrenzer 36 eingestellt. Bei berührenden Verfahren dient der Begrenzer 36 zum Rückhalten des Trägerarms 5, damit der Weg für das Prüfstück 18 nicht versperrt wird. Der Abstand zum Prüfstück 18 wird von Gegengewicht 10 und Schraubenfeder 13 hingegen dahingehend beeinflusst, dass die Sonde 9 bei berührenden Verfahren vom Prüfstück 18 abhebt, bzw. bei berührungslosen Verfahren der Kontakt zum Begrenzer 36 verloren geht.

Während des Drehens des Rotierkopfes 1 sind die Schraubenfedern 13 und 17 Zentrifugalkräften ausgesetzt. Diese Zentrifugalkräfte beeinflussen die Federspannungen der Schraubenfedern 13 und 17 und damit die durch die Schraubenfedern 13 und 17 auf die jeweiligen Trägerarme ausgeübten Kräfte und Drehmomente. Aus diesem Grund wird der voreingestellte Abstand der Sonden 9 und 14 von der Oberfläche des Prüfstückes 18 bzw. deren Anpresskraft auf die Oberfläche des Prüfstückes 18 beeinflusst. Diese Beeinflussung ist zudem abhängig von der jeweiligen Rotationsgeschwindigkeit des Rotierkopfes 1.

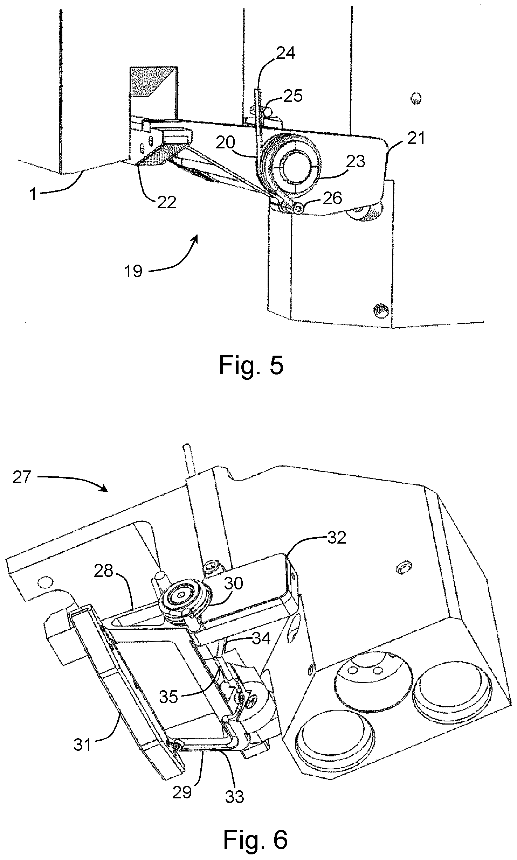

Um diesen Einfluss der Zentrifugalkräfte zu vermeiden, ist in der Sondeneinrichtung 19, die in der Figur 4 in einer schematischen Seitenansicht und in der Figur 5 in einer räumlichen Ansicht dargestellt ist, anstelle einer Schraubenfeder ein gekrümmtes Federelement vorgesehen. Bei diesem handelt es sich vorliegend um eine Schenkelfeder 20. Wie die zuvor beschriebene Sondeneinrichtung 3 weist auch die Sondeneinrichtung 19 um die Drehachse 8 drehbar gelagerte Trägerarme 21 für eine Sonde 22 auf. Eine Aufnahme 23 für die Schenkelfeder 20 ist konzentrisch zur Drehachse 8 jeweils an einem der Trägerarme 21 vorgesehen. Die Schenkelfeder 20 ist auf der Aufnahme 23 angeordnet und mehrmals um die Aufnahme 23 gewickelt. Mit einem Endabschnitt 24 liegt die Schenkelfeder 20 an einem vorstehenden Anschlag oder Anschlagsstift 25 des Rotierkopfes 1 an und ist dadurch an diesem abgestützt. Zudem greift die Schenkelfeder 20 an einer von der Drehachse 8 beabstandeten Stelle am Trägerarm 21 an, wobei sie im vorliegenden Fall an dieser Stelle mittels einer Befestigung 26 am Trägerarm 21 fixiert ist.

Infolge des gegen den Anschlagsstift 25 drückenden Endabschnittes 24 der Schenkelfeder 20 und deren Fixierung mittels der Befestigung 26, durch die sie am Trägerarm 21 angreift, ist es der Schenkelfeder 20 möglich, Kräfte und Drehmomente auf den Trägerarm 21 auszuüben. Hingegen ist es im Betrieb des Rotierkopfes 1 auftretenden Zentrifugalkräften nicht möglich, die Biegespannung der Schenkelfeder 20 zu erhöhen und dadurch die durch die Schenkelfeder 20 auf den Trägerarm 21 einwirkenden Kräfte und bewirkten Drehmomente zu beeinflussen, da die Schenkelfeder 20 konzentrisch zur Drehachse 8 angeordnet ist. Stattdessen wird die Schenkelfeder 20 durch die Zentrifugalkräfte gegen die Aufnahme 23 gedrückt, ohne dass dabei deren Biegespannung beeinflusst wird. Aus diesem Grund ist auch der Anpressdruck der Sonde 22 gegen die Oberfläche des Prüfstücks 18 bzw. deren Abstand voneinander unabhängig von der Rotationsgeschwindigkeit des Rotierkopfes 1 und dem Durchmesser des Prüfstücks 18.

Bei Drehung des Rotierkopfes 1 erfahren auch Sondenkabel, die in den Kabelführungen der bekannten Sondeneinrichtungen 3 und 4 aufgenommen sind und die nach Austritt aus deren zweiten Endabschnitten 12 und 16 bogenförmig bis zu einem Anschluss oder Einlass des Rotierkopfs 1 verlaufen, Zentrifugalkräfte. Diese Zentrifugalkräfte üben wiederum eine Hebelwirkung auf die drehbar gelagerten Sondeneinrichtungen 3 und 4 aus, wodurch der voreingestellte Abstand der Sonden 9 und 14 von der Oberfläche des Prüfstückes 18 bzw. deren Anpresskraft auf die Oberfläche des Prüfstückes 18 beeinflusst wird

Figur 6 zeigt nun eine Sondeneinrichtung 27, bei der auch diese Problematik überwunden ist. Im Unterschied zu den oben beschriebenen bekannten Sondeneinrichtungen 3 und 4 umfasst die Sondeneinrichtung 27 zwei Trägerarme 28 und 29, die als einstückiges Bauteil ausgebildet sind. Beide Trägerarme 28 und 29 sind um dieselbe Drehachse drehbar gelagert, wobei deren Drehung auf die oben beschriebene Weise von einer Schenkelfeder 30 beeinflusst wird. An einem Ende der Trägerarme 28 und 29 wird eine sich zwischen den Trägerarmen 28 und 29 erstreckende Sonde 31 gehalten, während an dem dazu entgegengesetzten Ende des Trägerarmes 29 ein Gegengewicht 32 angeordnet ist.

Die Sondeneinrichtung 27 unterscheidet sich nicht nur durch die einteilig ausgeführten Trägerarme 28 und 29 von den zuvor beschriebenen Sondeneinrichtungen 3 und 4, sondern zudem durch deren Kabelführung zur Aufnahme von Sondenkabeln. So weist die Kabelführung der Sondeneinrichtung 27 einen entlang des Trägerarms 28 von der Sonde 31 zur Drehachse verlaufenden ersten Endabschnitt 33 auf. Ein zweiter Endabschnitt 34 geht im Wesentlichen von der Drehachse aus bzw. schließt mit dieser einen Winkel ein. Der erste Endabschnitt 33 und der zweite Endabschnitt 34 sind mittels eines Kabelführungsabschnittes 35 verbunden, der als Hohlwelle ausgeführt entlang der Drehachse verläuft. Im eingebauten Zustand der Sondeneinrichtung 27 im Rotierkopf 1 ist der zweite Endabschnitt 34 relativ zum Rotierkopf 1 fest bzw. unbeweglich angeordnet, während die Trägerarme 28 und 29 um die Drehachse drehbar sind und damit relativ zum zweiten Endabschnitt 34 eine Rotationsbewegung ausführen können. Innerhalb des hohlen Kabelführungsabschnittes 35 kann sich ein Sondenkabel bei Kippen der Trägerarme 28 und 29 flexibel verdrehen, ohne seine Lage bzw. seinen Abstand relativ zur Drehachse signifikant zu verändern. Am Trägerarm 29 ist eine der Kabelführung des Trägerarmes 28 entsprechende Kabelführung vorgesehen.

Infolge der besonderen Kabelführung mit dem auf die Drehachse zulaufenden ersten Endabschnitt 33, dem von der Drehachse ausgehenden zweiten Endabschnitt 34 und dem zur Drehachse parallelen Kabelführungsabschnitt 35 lässt sich ein Sondenkabel derart führen, dass sich bei Rotation des Rotierkopfes 1 der Einfluss der Zentrifugalkraft auf die Sondeneinrichtung 27 minimieren lässt. Insbesondere treten bei der Sondeneinrichtung 27 keinerlei Kabelbögen auf, die einer derartigen Zentrifugalkraft ausgesetzt wären und diese an die Trägerarme 28 und 29 übertragen würden. Wenn sich zum Beispiel der Trägerarm 28 um die Drehachse dreht, kann sich das Sondenkabel innerhalb des hohlen Kabelführungsabschnittes 35 frei verwinden, ohne seine Form zu verändern oder sich von der Drehachse zu entfernen, so dass es auch keine Kräfte infolge der Rotation des Rotierkopfes 1 auf die Sondeneinrichtung 27 ausüben kann. Damit kann die Sondeneinrichtung 27 entsprechend dem Gewicht der Sonde 31 einmalig über das Gegengewicht 32 ausgewogen werden. Die ausgewogene Sondeneinrichtung 27 funktioniert dann über den gesamten Durchmesser- und Drehzahlbereich des Rotierkopfes 1 gleichermaßen. Die Anpresskraft an das Prüfstück 18 bzw. der Abstand der Sonde 31 von dessen Oberfläche ist somit von der Zentrifugalkraft unabhängig.

Bei einer anderen Ausführungsform einer erfindungsgemäßen Sondeneinrichtung wird von einem hohlen Kabelführungsabschnitt abgesehen und der erste Endabschnitt ist mit dem zweiten Endabschnitt direkt verbunden.

### Bezugszeichenliste

- 1.: Rotierkopf
- 2.: Durchgangsloch
- 3.: Sondeneinrichtung
- 4.: Sondeneinrichtung
- 5.: Trägerarm
- 6.: Trägerarm
- 7.: Mittelsteg
- 8.: Drehachse
- 9.: Sonde
- 10.: Gegengewicht
- 11.: erster Endabschnitt
- 12.: zweiter Endabschnitt
- 13.: Schraubenfeder
- 14.: Sonde
- 15.: Gegengewicht
- 16.: zweiter Endabschnitt
- 17.: Schraubenfeder
- 18.: Prüfstück
- 19.: Sondeneinrichtung
- 20.: Schenkelfeder
- 21.: Trägerarm
- 22.: Sonde
- 23.: Aufnahme
- 24.: Endabschnitt
- 25.: Anschlagsstift
- 26: Befestigung
- 27.: Sondeneinrichtung
- 28.: Trägerarm
- 29.: Trägerarm
- 30.: Schenkelfeder
- 31.: Sonde
- 32.: Gegengewicht
- 33.: erster Endabschnitt
- 34.: zweiter Endabschnitt
- 35.: Kabelführungsabschnitt
- 36.: Begrenzer

## Patentansprüche

1. Sondeneinrichtung (19, 27) für einen Rotierkopf (1), der ein zentrales Durchgangsloch (2) aufweist, die
wenigstens einen um eine Drehachse (8) drehbar gelagerten Trägerarm (21, 28, 29),
wenigstens eine mit dem Trägerarm (21, 28, 29) verbundene Sonde (22, 31), die an einem dem Durchgangsloch (2) zugewandten Ende des Trägerarmes (21, 28, 29) gehalten ist, sowie
wenigstens ein an dem Rotierkopf (1) abstützbares und an dem Trägerarm (21, 28, 29) angreifendes Federelement (20, 30) aufweist, das zum Ausüben einer Kraft auf den Trägerarm (21, 28, 29) vorgesehen ist, der infolge dieser Kraft ein Drehmoment bezüglich der Drehachse (8) erfährt,
wobei der Trägerarm (21, 28, 29) wenigstens eine mit der Drehachse (8) konzentrische Aufnahme (23) für das Federelement (20, 30) aufweist, und wobei das Federelement (20, 30) an der Aufnahme (23) angeordnet sowie mit wenigstens einer Wicklung um die Aufnahme (23) gewickelt und um die Drehachse (8) gekrümmt ist.

2. Sondeneinrichtung (19, 27) nach Anspruch 1, bei der das Federelement (20, 30) eine Biege- oder Spiral- oder Elliptik- oder Parabel- oder Wellen- oder Draht- oder Schenkelfeder ist.

3. Sondeneinrichtung (19, 27) nach Anspruch 1 oder 2, bei der das Federelement (20, 30) einen Stützabschnitt (24) zum Abstützen an einem Anschlag (25) des Rotierkopfes (1) aufweist.

4. Sondeneinrichtung (19, 27) nach einem der vorhergehenden Ansprüche mit wenigstens einer mechanischen Drehwinkelbegrenzung (36) für den Trägerarm (21, 28, 29) und/oder die Sonde (22, 31).

5. Sondeneinrichtung (27) nach einem der vorhergehenden Ansprüche mit wenigstens einer Kabelführung zum Führen eines Sondenkabels, wobei die Kabelführung einen entlang des Trägerarms (28, 29) von der Sonde (31) zur Drehachse verlaufenden ersten Endabschnitt (33) und einen im Wesentlichen von der Drehachse ausgehenden zweiten Endabschnitt (34) aufweist.

6. Sondeneinrichtung (27) nach Anspruch 5, bei welcher der erste Endabschnitt (33) und der zweite Endabschnitt (34) direkt miteinander verbunden sind oder bei welcher ein entlang der Drehachse verlaufender Kabelführungsabschnitt (35) den ersten Endabschnitt (33) und den zweiten Endabschnitt (34) miteinander verbindet.

7. Sondeneinrichtung (19, 27) nach einem der vorhergehenden Ansprüche, wobei der Trägerarm (21, 28, 29) nach Art eines einseitigen oder eines zweiseitigen Hebels gelagert ist.

8. Sondeneinrichtung (19, 27) nach einem der vorhergehenden Ansprüche mit wenigstens einem am Trägerarm (21, 28, 29) angeordneten Gegengewicht (32).

9. Rotierkopf (1) mit wenigstens einer Sondeneinrichtung (19, 27) gemäß einem der vorhergehenden Ansprüche.

10. Prüfgerät mit wenigstens einer Sondeneinrichtung (19, 27) gemäß einem der Ansprüche 1 bis 8 und/oder mit wenigstens einem Rotierkopf (1) gemäß Anspruch 9.

11. Prüfgerät nach Anspruch 10 mit wenigstens einem Paar an Sondeneinrichtungen (19, 27), deren Sonden (22, 31) einander zugewandt angeordnet sind.

## Claims

1. Probe device (19, 27) for a rotary head (1) which has a central through-hole (2), the probe device having
at least one carrier arm (21, 28, 29) mounted rotatably about an axis of rotation (8),
at least one probe (22, 31) connected to the carrier arm (21, 28, 29) and held on an end of the carrier arm (21, 28, 29) facing towards the through-hole (2), and
at least one spring element (20, 30) which can be supported on the rotary head (1) and engages on the carrier arm (21, 28, 29) and is provided to exert a force on the carrier arm (21, 28, 29), which as a result of this force experiences a torque with respect to the axis of rotation (8),
wherein the carrier arm (21, 28, 29) has at least one receptacle (23), concentric with the axis of rotation (8), for the spring element (20, 30), and wherein the spring element (20, 30) is arranged on the receptacle (23) and is wound with at least one winding around the receptacle (23) and is curved about the axis of rotation (8).

2. Probe device (19, 27) according to Claim 1, wherein the spring element (20, 30) is a flexural or spiral or elliptical or parabolic or wave or wire or leg spring.

3. Probe device (19, 27) according to Claim 1 or 2, wherein the spring element (20, 30) has a support portion (24) for supporting on a stop (25) of the rotary head (1).

4. Probe device (19, 27) according to any one of the preceding claims, having at least one mechanical rotation angle limitation (36) for the carrier arm (21, 28, 29) and/or the probe (22, 31).

5. Probe device (27) according to any one of the preceding claims, having at least one cable guide for guiding a probe cable, wherein the cable guide has a first end portion (33) running along the carrier arm (28, 29) from the probe (31) to the axis of rotation and a second end portion (34) starting substantially from the axis of rotation.

6. Probe device (27) according to Claim 5, wherein the first end portion (33) and the second end portion (34) are directly connected to each other, or wherein a cable guide portion (35) extending along the axis of rotation connects the first end portion (33) and the second end portion (34) to each other.

7. Probe device (19, 27) according to any one of the preceding claims, wherein the carrier arm (21, 28, 29) is mounted in the manner of a one-sided or a two-sided lever.

8. Probe device (19, 27) according to any one of the preceding claims, having at least one counterweight (32) arranged on the carrier arm (21, 28, 29).

9. Rotary head (1) having at least one probe device (19, 27) according to any one of the preceding claims.

10. Test apparatus having at least one probe device (19, 27) according to any one of Claims 1 to 8 and/or having at least one rotary head (1) according to Claim 9.

11. Test apparatus according to Claim 10, having at least one pair of probe devices (19, 27), the probes (22, 31) of which are arranged facing each other.

## Revendications

1. Dispositif à sonde (19, 27) pour une tête rotative (1) qui comporte un trou traversant (2) central, qui comporte
au moins un bras de support (21, 28, 29) monté de manière à pouvoir tourner autour d'un axe de rotation (8),
au moins une sonde (22, 31) reliée au bras de support (21, 28, 29), qui est maintenue sur une extrémité du bras de support (21, 28, 29) tournée vers le trou traversant (2), ainsi
qu'au moins un élément de ressort (20, 30) pouvant prendre appui sur la tête rotative (1) et s'engageant sur le bras de support (21, 28, 29), lequel est prévu pour exercer une force sur le bras de support (21, 28, 29), qui subit, du fait de cette force, un couple de rotation par rapport à l'axe de rotation (8),
le bras de support (21, 28, 29) comportant au moins un logement (23) concentrique à l'axe de rotation (8) pour l'élément de ressort (20, 30), et l'élément de ressort (20, 30) étant disposé sur le logement (23) et étant également enroulé autour du logement (23) avec au moins un enroulement et étant incurvé autour de l'axe de rotation (8).

2. Dispositif à sonde (19, 27) selon la revendication 1, dans lequel l'élément de ressort (20, 30) est un ressort de flexion ou en spirale ou elliptique ou parabolique ou ondulé ou à boudin ou à branches.

3. Dispositif à sonde (19, 27) selon la revendication 1 ou 2, dans lequel l'élément de ressort (20, 30) comporte une section d'appui (24) destinée à prendre appui sur une butée (25) de la tête rotative (1).

4. Dispositif à sonde (19, 27) selon l'une des revendications précédentes avec au moins un système de limitation d'angle de rotation (36) mécanique pour le bras de support (21, 28, 29) et/ou la sonde (22, 31).

5. Dispositif à sonde (27) selon l'une des revendications précédentes avec au moins un guide-câble destiné à guider un câble de sonde, le guide-câble comportant une première section d'extrémité (33) s'étendant le long du bras de support (28, 29) depuis la sonde (31) vers l'axe de rotation et une seconde section d'extrémité (34) partant sensiblement de l'axe de rotation.

6. Dispositif à sonde (27) selon la revendication 5, dans lequel la première section d'extrémité (33) et la seconde section d'extrémité (34) sont directement reliées l'une à l'autre ou dans lequel une section de guide-câble (35) s'étendant le long de l'axe de rotation relie la première section d'extrémité (33) et la seconde section d'extrémité (34) l'une à l'autre.

7. Dispositif à sonde (19, 27) selon l'une des revendications précédentes, le bras de support (21, 28, 29) étant monté à la manière d'un levier à un côté ou à deux côtés.

8. Dispositif à sonde (19, 27) selon l'une des revendications précédentes avec au moins un contrepoids (32) disposé sur le bras de support (21, 28, 29).

9. Tête rotative (1) avec au moins un dispositif à sonde (19, 27) selon l'une des revendications précédentes.

10. Appareil de test avec au moins un dispositif à sonde (19, 27) selon l'une des revendications 1 à 8 et/ou avec au moins une tête rotative (1) selon la revendication 9.

11. Appareil de test selon la revendication 10 avec au moins une paire de dispositifs à sonde (19, 27), dont les sondes (22, 31) sont disposées en vis-à-vis.
